# EUROPÄISCHE PATENTANMELDUNG

(11) **EP 4 343 860 A2**
(43) Veröffentlichungstag der Anmeldung: **27.03.2024**
(21) Anmeldenummer: 24151179.9
(22) Anmeldetag: 01.02.2022
(51) Int. Cl.: H01L 31/18

(54) **BESTÜCKUNG EINER TRANSPORTEINHEIT BEIM HERSTELLEN VON SOLARMODULEN**

(30) Priorität: 11.03.2021 DE 102021105987
(62) Teilanmeldung aus: 22706262.7
(71) Anmelder: M10 Solar Equipment GmbH, 79111 Freiburg (DE)
(72) Erfinder: Zahn, Philipp Donatus Martin, 79117 Freiburg (DE); Schneidereit, Günter, 79112 Freiburg (DE); Jehl, Dominique, 67860 Rhinau (FR)
(74) Vertreter: Mertzlufft-Paufler, Cornelius

(57) **Zusammenfassung**

Es ist beschrieben ein Verfahren zum Herstellen von Solarmodulen, wobei Solarelemente zu Zeilen zusammengesetzt werden, wobei jede Zeile wenigstens zwei Solarelemente aufweist, wobei die Solarmodule aus elektrisch miteinander verbundenen Zeilen aufgebaut werden, wobei zur Bestückung des Solarmoduls wenigstens zwei Zeilen in einem Arbeitsgang aufgenommen und in unterschiedlichen Höhen über dem Solarmodul bereitgehalten werden und wobei die Zeilen zur Bestückung des Solarmoduls miteinander jeweils nur soweit abgesenkt werden, dass nur die jeweils aktuell zu bestückende Zeile das Solarmodul kontaktiert.

## Beschreibung

Die Erfindung betrifft ein Verfahren zur Herstellung von Solarmodulen, wobei Solarelemente zu Zeilen zusammengesetzt werden, wobei jede Zeile wenigstens zwei Solarelemente aufweist und wobei die Solarmodule aus elektrisch miteinander verbundenen Zeilen aufgebaut werden.

Die Solarelemente, die zu Zeilen zusammengesetzt werden, können Solarzellen, photovoltaische Solarzellen, Photovoltaikzellen oder daraus Teilgeschnittene Teile, so genannte Schindel, also beispielsweise Solarzellen-Schindel oder Photovoltaikzellen-Schindel, sein.

In einem solchen Verfahren können einzelnen Solarelemente bzw. Grundelemente einer Solarzelle, zeilenweise auf eine Transfereinheit verbracht werden, die Transfereinheit in einen Assembling-Bereich verfahren und die Solarelemente in dem Assembling-Bereich zeilenweise auf einem Tray oder einer anderen Transporteinheit, insbesondere einer motorisierten Transporteinheit, abgelegt werden. Das Ablegen des Solarelements auf der motorisierten Transporteinheit zum Bereitstellen eines Solarmoduls wird auch als Bestückung des Solarmoduls bezeichnet. Der Assembling-Bereich wird daher auch als Bestückungs-, Montage oder Aufbau-Bereich bezeichnet.

Zur Bestückung des Solarmoduls, insbesondere eines einstückigen Solarmoduls, können die Zeilen, also die Zeilen an Solarelementen oder zeilenweise angeordneten Solarelementen, entlang einer Längsachse zweier nebeneinander angeordneten Zeilen einander überlappend angeordnet sein. Im Bereich der Überlappung kann ein Kleber oder ein anderes Befestigungsmittel zur Verbindung der nebeneinander angeordneten Zeilen angebracht sein. Der Kleber kann beispielsweise auf den Solarelementen bzw. den Zeilen, die sich auf der Transfereinheit befinden, angebracht werden. Zur Anbringung des Klebers können Abgabeeinheiten verwendet werden. Beispielsweise können Dispenser verwendet werden, die linienförmige Klebstoffaufträge ausführen können. Alternativ kann der Kleber durch eine Druckvorrichtung angebracht werden. Beispielsweise kann der Kleber mittels eines Druckverfahrens, wie beispielsweise Rollendruck oder Siebdruck, angebracht werden. Die mit dem Kleber versehenen Zeilen können auf der motorisierten Transporteinheit an- bzw. miteinander ausgerichtet und verbunden werden und derart zu einem Solarmodul zusammengesetzt werden.

Bei derartigen Verfahren spielt die benötigte Zeit zwischen der Bereitstellung eines einzelnen Solarelements und der Bestückung eines Solarmoduls mit dem einzelnen Solarelements, auch bezeichnet als die Zykluszeit, eine entscheidende Rolle. Eine verkürzte Zykluszeit führt zu einer erheblichen Verkürzung der Bearbeitungszeit zur Herstellung des gesamten Solarmoduls. Der Erfindung liegt daher die Aufgabe zu Grunde, die Effizienz eines Verfahrens zur Herstellung von Solarmodulen zu erhöhen, insbesondere ein solches Verfahren zu beschleunigen.

Die Lösung diese Aufgabe besteht bei dem Verfahren eingangs erwähnter Art insbesondere darin, dass zur Bestückung des Solarmoduls wenigstens zwei Zeilen in einem Arbeitsgang aufgenommen und in unterschiedlichen Höhen über dem Solarmodul bereitgehalten werden und dass die Zeilen zur Bestückung des Solarmoduls miteinander jeweils nur soweit abgesenkt werden, dass nur die jeweils aktuell zu bestückende Zeile das Solarmodul kontaktiert.

Der Erfindung liegt die Erkenntnis zu Grunde, dass die Zykluszeit verkürzt werden kann, in dem einzelne Verfahrensschritte für mehrere Solarzellen gleichzeitig durchgeführt werden. Beispielsweise werden in dem erfindungsgemäßen Verfahren, mehrere Zeilen, also wenigstens zwei Zeilen, in einem Arbeitsgang von der Transfereinheit durch eine Aufnahmevorrichtung aufgenommen, um diese in einem nachfolgenden Schritt auf die motorisierte Transporteinheit abzulegen. Die motorisierte Transporteinheit stellt beispielsweise ein Tray oder ein Förderband dar. Dabei ermöglicht das erfindungsgemäße Verfahren weiterhin eine nacheinander erfolgende Ablage von sich nach der Ablage überlagernden wenigstens zwei Zeilen. Hierdurch wird die Anzahl der Aufnahmeprozesse sowie der Verfahrweg der Aufnahmevorrichtung innerhalb eines Herstellungsprozesses eines Solarmoduls verkleinert und die für das Herstellungsverfahren benötigte Zeit verkürzt. Somit die Effizienz des eingangs erwähnten Verfahrens erhöht.

In einer Ausgestaltung ist vorgesehen, dass die verbleibenden Zeilen von dem Solarmodul vertikal beabstandet bleiben. Beispielsweise werden zwei oder drei Zeilen gleichzeitig von der Aufnahmevorrichtung aufgenommen und über dem Solarmodul bereitgestellt. Bei dem erfindungsgemäßen Verfahren kann die Aufnahmevorrichtung in vertikaler Richtung an das Solarmodul angenähert werden, bis eine erste, bzw. die aktuell zu bestückende Zeile, das Solarmodul kontaktiert, beispielsweise eine vorher abgelegte Zeile überlappend kontaktiert, und eine zweite und dritte Zeile, bzw. die verbleibenden Zeilen, durch ihren vertikalen Abstand beim Kontakt der ersten Zeile mit dem Solarmodul weiterhin von dem Solarmodul vertikal beabstandet bleiben. Derart kann das Solarmodul durch die Aufnahmevorrichtung mit einer Zeile bei gleichzeitiger Führung mehrerer Zeilen bestückt werden. In einem oder mehreren weiteren Ablageschritten kann das Solarmodul durch die weiteren Zeilen bestückt werden.

In einer Ausgestaltung ist vorgesehen, dass die Zeilen mit vorzugsweise gegen eine Rückstellkraft vertikal verstellbaren Saugern aufgenommen werden. Beispielsweise werden die in Zeilen angeordneten Solarelemente jeweils mit zumindest einem Sauger aufgenommen. Dabei können die Sauger derart angeordnet sein, dass die Sauger für die erste Zeile in vertikaler Richtung über die Sauger für die zweite Zeile in Richtung der aufzunehmenden Zeilen hinausragen. Die Sauger für die zweite Zeile können wiederum über Sauger für eine weitere, dritte Zeile in Richtung der Zeilen vertikal hinausragen, usw. Dies ermöglicht eine selektive Aufnahme bzw. selektive Ablage einer einzelnen Zeile, beispielsweise das Ablegen der ersten Zeile, ohne die zweite Zeile abzulegen. Die beispielsweise gegen eine Rückstellkraft vertikal verstellbaren Sauger ermöglichen eine Aufnahme und Ablage einer weiteren, zweiten Zeile nachdem die erste Zeile aufgenommen bzw. abgelegt ist, insbesondere vor einer Aufnahme bzw. Ablage einer oder mehrere weiteren, dritten Zeilen. Mit anderen Worten: Dies ermöglicht also eine gemeinsame Aufnahme mehrerer Zeilen, insbesondere mit einer Nachfolgenden selektiven Ablage der gemeinsam aufgenommenen Zeilen.

Als ein weiterer möglicherweise eigenständiger Aspekt besteht die Lösung der eingangs genannten Aufgabe bei dem Verfahren der eingangs erwähnten Art alternativ insbesondere darin, dass zwei aufeinanderfolgende Zeilen während des Bestückungsvorgangs unterschiedliche Wegstrecken zurücklegen. Beispielsweise wird die Aufnahmevorrichtung während des Bestückungsvorgans senkrecht zu den Zeilen, d.h. senkrecht zu einer Längsrichtung der Zeilen, bewegt. Beispielsweise wird von der Aufnahmevorrichtung eine erste Zeile und mindestens eine zweite Zeile aufgenommen. In diesem Fall wird die Aufnahmevorrichtung beispielsweise nach Ablage der ersten Zeile auf der motorisierten Transporteinheit und vor Ablage der zweiten Zeile auf der motorisierten Transporteinheit senkrecht zu und relativ zu der ersten Zeile bewegt, z.B. motorisiert oder mechanisch verfahren. Derart wird bei der Bestückung eine Bewegung der motorisierten Transporteinheit durch eine Bewegung der Aufnahmevorrichtung, die die Zeilen von der Transfereinheit auf die Transporteinheit bewegt, ergänzt und/oder ersetzt. Derart können die einzelnen Zeilen in zeitlich und räumlich effektiver Weise auf der Transporteinheit angeordnet werden.

Bei einer Ausführungsform des Verfahrens ist vorgesehen, dass während eines Bestückungsvorgangs zur Bestückung des Solarmoduls zwei aufeinanderfolgenden Zeilen in einem Arbeitsgang aufgenommen werden. Es ist ferner möglich, dass die zwei aufeinanderfolgenden Zeilen während des Bestückungsvorgangs unterschiedlich lange Wegstrecken zurücklegen.

In einer Ausgestaltung ist vorgesehen, dass das Solarmodul während des Bestückungsvorgangs mit den zwei aufeinanderfolgenden Zeilen ortsfest verbleibt. Mit anderen Worten: Die Transporteinheit wird in dieser Ausgestaltung während der Bestückung nicht bewegt. In dieser Ausgestaltung kann die Aufnahmevorrichtung sich nach der Ablage der ersten Zeile senkrecht zur abgelegten ersten Zeile bewegen, um anschließend an und überlappend mit der ersten Zeile die zweite Zeile zur Bestückung des Solarmoduls auf der Transporteinheit abzulegen. Derart ist die relative Anordnung der Zeilen zumindest auch durch die Bewegung der Aufnahmevorrichtung bestimmbar bzw. einstellbar. Alternativ wird die Transporteinheit während der Bestückung bewegt.

In einer Ausgestaltung ist vorgesehen, dass das Solarmodul zwischen zwei Bestückungsvorgängen getaktet bewegt wird. Eine getaktete Bewegung des Solarmoduls bzw. der Transporteinheit kann bei der Bestückung der Transporteinheit durch die Zeilen vorteilhaft sein. Bei der Bestückung werden die Zeilen auf der Transporteinheit aneinander ausgerichtet und verbunden. Durch eine getaktete Vorwärtsbewegung kann dabei an der Stelle der Bestückung Platz geschaffen werde für neue, auf der Transporteinheit anzuordnende Reihen. So ist es denkbar, dass die Aufnahmevorrichtung sich bewegt, um alle aufgenommenen Zeilen nacheinander abzugeben, während die Transporteinheit sich bewegt, wenn die Aufnahmevorrichtung neue Ladung aufnehmen soll.

In einer Ausgestaltung ist vorgesehen, dass das Solarmodul zwischen zwei Bestückungsvorgängen, nämlich zwischen einer Ablage der in dem einen Arbeitsgang aufgenommenen Zeilen und einer Ablage weiterer, in einem weiteren Arbeitsgang aufgenommener Zeilen, getaktet bewegt wird.

Derart ist die relative Anordnung der Zeilen während der Bestückung allein durch die Bewegung der Aufnahmevorrichtung bestimmbar, während die Bewegung der Transporteinheit einen kleineren und damit kürzeren Verfahrweg der Aufnahmevorrichtung bei der Bestückung ermöglicht. Auf diese Weise kann die Bestückung der Transporteinheit vereinfacht, insbesondere schneller, und mit erhöhter Präzision durchgeführt werden.

In einer Ausgestaltung ist vorgesehen, dass das Solarmodul während des Bestückungsvorgangs kontinuierlich bewegt wird. Insbesondere wird das Solarmodul während des Bestückungsvorgangs senkrecht zu den Zeilen bewegt. Mit anderen Worten: Die Transporteinheit wird während des Bestückungsvorgangs kontinuierlich bewegt. Hierdurch kann der Herstellungsprozess der Solarmodule weiter beschleunigt werden. Dies insbesondere deshalb, da sich eine Zeile während und nach der Bestückung des Moduls mit dieser Zeile weiterbewegt und damit schneller einen nachfolgenden Verfahrensschritt erreicht.

In einem nachfolgenden Verfahrensschritt können die Solarmodule beispielsweise zur thermischen Behandlung, d.h. zu Aushärtung des Klebemittels in einen Bereich der thermischen Einwirkung, beispielsweise in einen Ofen, bewegt werden. Dabei können sich die Solarmodule weiterhin auf der Transporteinheit befinden. Hierbei ist die kontinuierliche Bewegung der Transporteinheit vorteilhaft. Denn durch eine getaktete Bewegung entstehen Überlappbereiche der thermischen Einwirkung, hervorgerufen durch eine unterschiedliche Verweilzeit der Reihen von Solarzellen unter thermischer Einwirkung, die entweder zu starke oder zu schwache thermische Einwirkung und somit ein Streifenmuster ergeben. Bei einer kontinuierlichen Bewegung des Solarmoduls bzw. der Transporteinheit wird das Solarmodul hingegen gleichmäßig durch einen Bereich der thermischen Einwirkung, in dem der auf und zwischen den Zeilen angebrachten Kleber aushärtet, bewegt.

Die Bewegung des Transportsystem kann bei der Ablage einer Zeile durch eine entsprechende Bewegung der Aufnahmevorrichtung ausgeglichen werden. Derart kann eine Relativbewegung der Transporteinheit zu der Aufnahmevorrichtung bei der Ablage der Zeile verhindert werden. Alternativ kann die Dauer des Ablageprozesses so gewählt sein, insbesondere so kurz gewählt sein, dass die beschriebene Relativbewegung während des Ablegens der Zeile vernachlässigbar ist.

Als ein weiterer möglicherweise eigenständiger Aspekt besteht die Lösung der eingangs genannten Aufgabe insbesondere darin eine Vorrichtung zum Herstellen von Solarmodulen bereitzustellen, wobei Solarelemente zu Zeilen zusammengesetzt werden, wobei jede Zeile wenigstens zwei Solarelemente aufweist und wobei die Solarmodule aus elektrisch miteinander verbundenen Zeilen aufgebaut werden, wobei die Vorrichtung eine Aufnahmevorrichtung umfasst, die dazu ausgelegt ist, zur Bestückung des Solarmoduls wenigstens zwei Zeilen in einem Arbeitsgang aufzunehmen und in unterschiedlichen Höhen über dem Solarmodul bereitzuhalten und die Zeilen zur Bestückung des Solarmoduls miteinander jeweils nur soweit abzusenken, dass nur die jeweils aktuell zu bestückende Zeile das Solarmodul kontaktiert.

In einer Ausgestaltung ist vorgesehen, dass die Aufnahmevorrichtung dazu ausgelegt ist, die verbleibenden Zeilen von dem Solarmodul vertikal beabstandet zu halten.

In einer Ausgestaltung ist vorgesehen, dass die Aufnahmevorrichtung vorzugsweise gegen eine Rückstellkraft vertikal verstellbaren Sauger umfasst, die dazu ausgelegt sind, die Zeilen aufzunehmen, insbesondere die Zeilen gemeinsam in einem Arbeitsschritt aufzunehmen.

Als ein weiterer möglicherweise eigenständiger Aspekt besteht die Lösung der eingangs genannten Aufgabe insbesondere darin eine Vorrichtung zum Herstellen von Solarmodulen bereitzustellen, wobei Solarelemente zu Zeilen zusammengesetzt werden, wobei jede Zeile wenigstens zwei Solarelemente aufweist und wobei die Solarmodule aus elektrisch miteinander verbundenen Zeilen aufgebaut werden, wobei die Vorrichtung eine Aufnahmevorrichtung umfasst, die dazu ausgelegt ist, für mindestens zwei aufeinanderfolgende Zeilen während des Bestückungsvorgangs unterschiedliche Wegstrecken zurückzulegen. Dazu kann die Aufnahmevorrichtung in Laufrichtung der Transportvorrichtung und/oder in Vertikalrichtung, beispielsweise in eine Richtung längs der Zeilen, verfahren.

In einer Ausgestaltung ist vorgesehen, dass Vorrichtung, insbesondere ihre Aufnahmevorrichtung, dazu eingerichtet ist, während eines Bestückungsvorgangs zur Bestückung des Solarmoduls zwei aufeinanderfolgende Zeilen in einem Arbeitsgang aufzunehmen.

In einer Ausgestaltung ist vorgesehen, dass die Aufnahmevorrichtung dazu eingerichtet ist, für mindestens zwei aufeinanderfolgende Zeilen während des Bestückungsvorgangs unterschiedlich lange Wegstrecken zurückzulegen.

In einer Ausgestaltung ist vorgesehen, dass die Aufnahmevorrichtung vorzugsweise während des Bestückungsvorgangs relativ zu dem Solarmodul bewegbar ist, insbesondere in eine Richtung quer zu den Zeilen bewegbar ist. Alternativ oder ergänzend kann die Aufnahmevorrichtung vorzugsweise während des Bestückungsvorgangs in eine Richtung längs zu den Zeilen bewegbar sein.

In einer Ausgestaltung ist vorgesehen, dass die Vorrichtung eine Transporteinheit zur Aufnahme des Solarmoduls umfasst und die Vorrichtung dazu ausgelegt ist, die Transporteinheit während des Bestückungsvorgangs mit den zwei aufeinanderfolgenden Zeilen ortsfest zu halten.

In einer Ausgestaltung ist vorgesehen, dass die Vorrichtung dazu ausgelegt ist, die Transporteinheit zwischen zwei Bestückungsvorgängen getaktet zu bewegen. In einer Ausgestaltung ist vorgesehen, dass die Vorrichtung dazu ausgelegt ist, die Transporteinheit zwischen zwei Bestückungsvorgängen, nämlich zwischen einer Ablage der in dem einen Arbeitsgang aufgenommenen Zeilen und einer Ablage weiterer, in einem weiteren Arbeitsgang aufgenommener Zeilen, getaktet zu bewegen.

In einer Ausgestaltung ist vorgesehen, dass die Vorrichtung dazu ausgelegt ist die Transporteinheit insbesondere während des Bestückungsvorgangs kontinuierlich zu bewegen.

Nachstehend wird die Erfindung anhand mehrerer bevorzugter Ausführungsbeispiele noch näher beschrieben.

Es zeigt:
- Fig. 1A: eine erste Vorrichtung zur Herstellung von Solarmodulen in 3-dimensionaler Ansicht,
- Fig. 1B: die erste Vorrichtung in Draufsicht,
- Fig. 2A: eine zweite Vorrichtung zum Herstellen von Solarmodulen in 3-dimensionaler Ansicht,
- Fig. 2B: die zweite Vorrichtung in Draufsicht,
- Fig. 2C: die zweite Vorrichtung in Seitenansicht,
- Fig. 3A: eine dritte Vorrichtung zum Herstellen von Solarmodulen in 3-dimensionaler Ansicht,
- Fig. 3B: die dritte Vorrichtung in Draufsicht,
- Fig. 3C: die zweite Vorrichtung in Seitenansicht,
- Fig. 4A-H: eine erste Aufnahmevorrichtung, eine Transfereinheit und eine Transporteinheit der ersten, zweiten oder dritten Vorrichtung in Seitenansicht und in unterschiedlichen Anordnungen gemäß unterschiedlicher Verfahrensschritte,
- Fig. 5A: eine zweite Aufnahmevorrichtung der ersten, zweiten oder dritten Vorrichtung in Seitenansicht, und
- Fig. 5B: die zweite Aufnahmevorrichtung in dreidimensionaler Ansicht über einer Transporteinheit der ersten, zweiten oder dritten Vorrichtung sowie einen vergrößerten Ausschnitt der Aufnahmevorrichtung in Explosionsdarstellung.

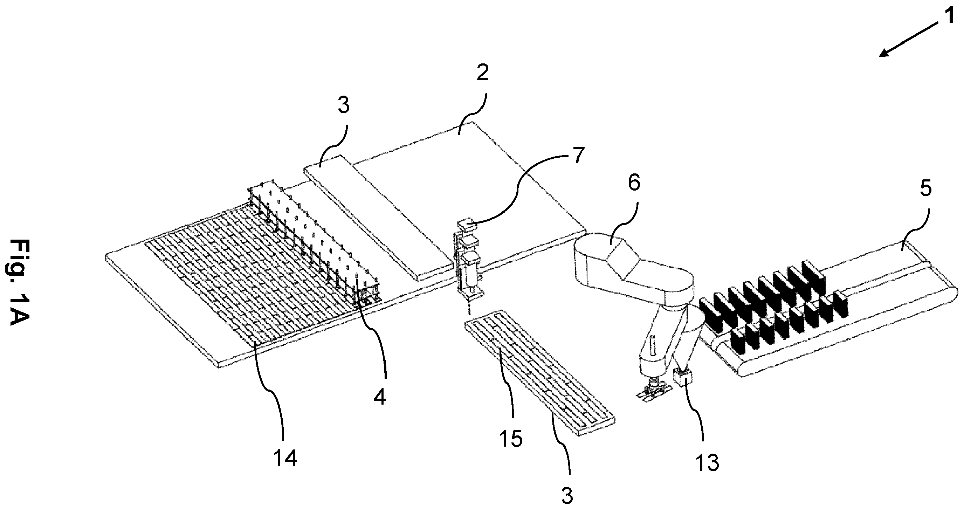

Figur 1A zeigt eine erste Vorrichtung 1 zur Herstellung von Solarmodulen 14 in 3-dimensionaler Ansicht. Die Vorrichtung 1 umfasst eine Transporteinheit 2, eine Transfereinheit 3 und eine Aufnahmevorrichtung 4. Wie in Figur 1A dargestellt sind auf der Transfereinheit 3 Solarelemente 15 angeordnet, die zu Zeilen zusammengesetzt sind. Im Vorliegenden Beispiel sind die Solarelemente 15 als sogenannte Schindel länglich ausgestaltet. Als Schindel werden auch Solarelemente 15 bezeichnet, die Streifen eines Wafers sind. Die auf der Transfereinheit 3 angeordnete Zeilen werden von der Aufnahmevorrichtung 4 aufgenommen und auf die Transporteinheit 2 abgelegt. In ein oder mehreren vorangehenden Schritten werden die Solarelemente 15 auf einer Bereitstelleinheit 5 bereitgestellt und von einer Handlingeinheit 6 auf der Transfereinheit 3 platziert. Der oder die vorangehenden Schritte können durch ein Überwachungssystem 13, beispielsweise ein Sensor- und/oder Kamerasystem, kontrolliert werden.

Die einzelnen Solarelemente 15 unterschiedlicher Reihen können dabei auf der Transfereinheit 3 jeweils in eine Richtung senkrecht zu den Reihen (bzw. senkrecht zu einer Längsrichtung der Reihen) beabstandet nebeneinander angeordnet sein. Alternativ können die einzelnen Solarelemente 15 unterschiedlicher Reihen wie in Figur 1A dargestellt in Querrichtung zu den Reihen beabstandet und in Längsrichtung zu den Reihen zueinander versetzt, in einem sogenannten Mauermuster, angeordnet sein.

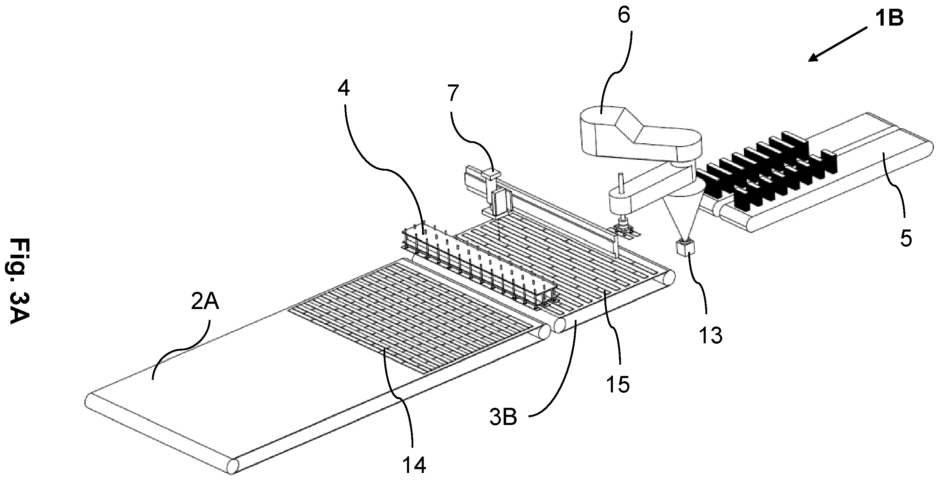

Die Transfereinheit 3 kann sich parallel, also in eine Richtung längs der Zeilen, zu den auf der Transporteinheit 4 abgelegten Zeilen bewegen. Die Transfereinheit 3 kann sich relativ zu der Transporteinrichtung 4 bewegen. Derart kann sich die Transfereinheit 3 von einer ersten Position, in der die Transfereinheit 3 mit den Solarelementen 15 durch die Handlingeinheit 6 bestückt wird, in eine zweite Position bewegen, in der die Zeilen von der Aufnahmevorrichtung 4 aufgenommen und auf die Transporteinheit 4 abgelegt werden. Auf dem Weg von der ersten in die zweite Position, werden die Solarelemente 15, bzw. die Zeilen, entlang zumindest einer Längsachse der Zeilen, mit einem Klebemittel versehen. Das Auftragen des Klebemittels erfolgt durch mehrere Abgabeeinheiten, im gezeigten Beispiel durch mehrere Dispenser 7, beispielsweise durch je einen Dispenser pro Zeile. Alternativ kann das Auftragen des Klebemittels durch nur einen Dispenser 7 erfolgen (siehe Figuren 3A-3C). Alternativ erfolgt das Auftragen des Klebemittels mittels eines Druckverfahrens, beispielsweise Siebdruck oder Rollendruck, mittels Druckeinheiten, beispielsweise Siebdruck- oder Rollendruck-Einheiten.

Nach dem Aufbringen des Klebemittels können die auf der Transfereinheit 3 angeordneten Zeilen auf der Transporteinheit 4 mit bereits dort abgelegten Zeilen verbunden werden. Das verbinden einer neu abgelegt Zeile geschieht mittels teilweise überlappendem Ablegen der neu abzulegenden Zeile auf einer bereits zuvor abgelegten Zeile, wobei das Klebemittel sowohl mit der bereits zuvor abgelegt Zeile und der neue abzulegenden Zeile in Kontakt tritt. Mit anderen Worten, die auf der Transporteinheit 4 angeordneten Zeilen überlappen sich teilweise, insbesondere in einem Bereich des aufgebrachten Klebemittels.

in einem nachfolgenden Verfahrensschritt können die auf der Transporteinheit 2 angeordneten und zu einem Solarmodul 14 zusammengesetzten Zeilen auf der Transporteinheit 2 bewegt werden. Die Transporteinheit 2 ist beispielsweise ein Tray oder ein Förderband. Die Transporteinheit 2 kann eine motorisierte Transporteinheit sein. Das bestückte Solarmodul 14 wird in dem nächsten Verfahrensschritt beispielsweise in einen Bereich thermischer Einwirkung, beispielsweise in einen Ofen, geführt, um den Kleber auszuhärten und damit die Zeilen innerhalb des Solarmoduls 14 fest miteinander zu verbinden.

Die Transporteinheit 2 kann während und/oder nach der Bestückungsvorgangs kontinuierlich oder getaktet bewegt werden. Insbesondere kann die Transporteinheit 2 während des Bestückungsvorgans und nach dem Bestückungsvorgang kontinuierlich bewegt werden. Alternativ kann die Transporteinheit 2 während des Bestückungsvorgans getaktet und nach dem Bestückungsvorgang kontinuierlich bewegt werden.

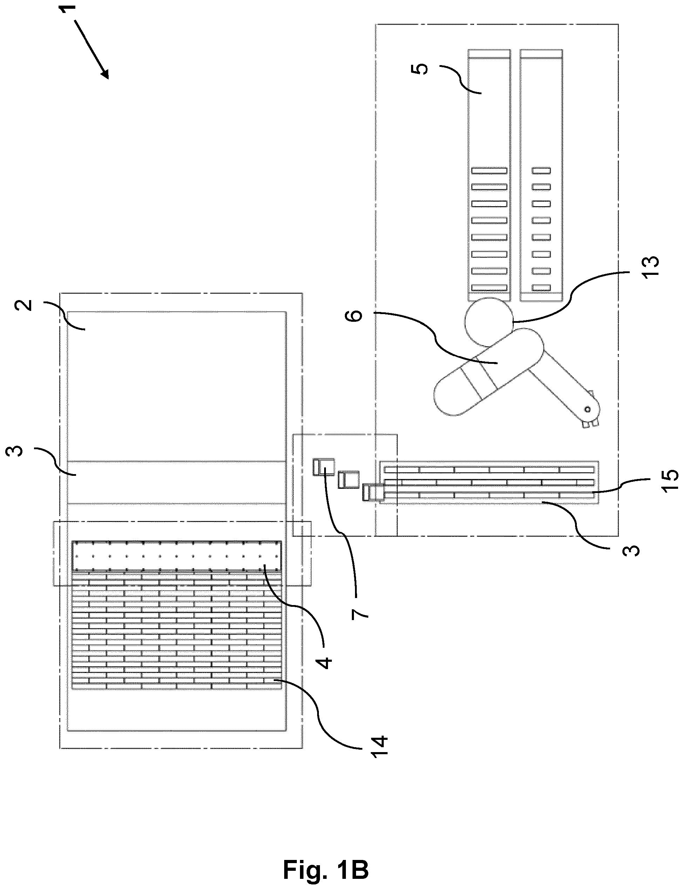

Figur 1B zeigt die erste Vorrichtung 1 aus Figur 1A in Draufsicht. Gleiche oder ähnliche Merkmale sind mit gleichen Bezugszeichen versehen.

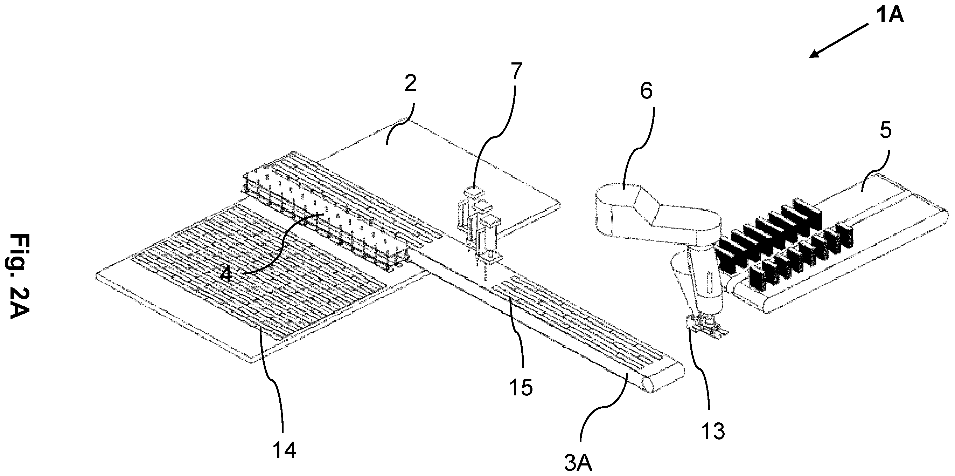

Figur 2A zeigt eine zweite Vorrichtung 1A zum Herstellen von Solarmodulen 14 in 3-dimensionaler Ansicht. Die zweite Vorrichtung 1A ist ähnlich der in den Figuren 1A und 1B gezeigten ersten Vorrichtung 1. Gleiche oder ähnliche Merkmale sind mit gleichen Bezugszeichen versehen. Anstelle der Transfereinheit 3 der Vorrichtung 1 umfasst die Vorrichtung 1A eine Transfereinheit 3A. Die Transfereinheit 3A ist als ein Förderband ausgestaltet. Das Förderband erstreckt sich von der mit Bezug auf die Figur 1 beschriebenen ersten Position der Transfereinheit 3 bis zur zweiten Position der Transfereinheit 3. Das Förderband ist parallel zu den darauf angeordneten Zeilen und parallel zu den auf der Transporteinheit 2 abgelegten Zeilen bewegbar. Mit anderen Worten, das Förderband ist in eine Längsrichtung der Zeilen bewegbar. Derart können die auf der Transfereinheit 3A abgelegten und in Zeilen angeordneten Solarelemente 15 durch Bewegung des Förderband von der ersten Position in die zweite Position bewegt werden, von der aus sie mittels der Aufnahme 4 auf die Transporteinheit 2 abgelegt werden.

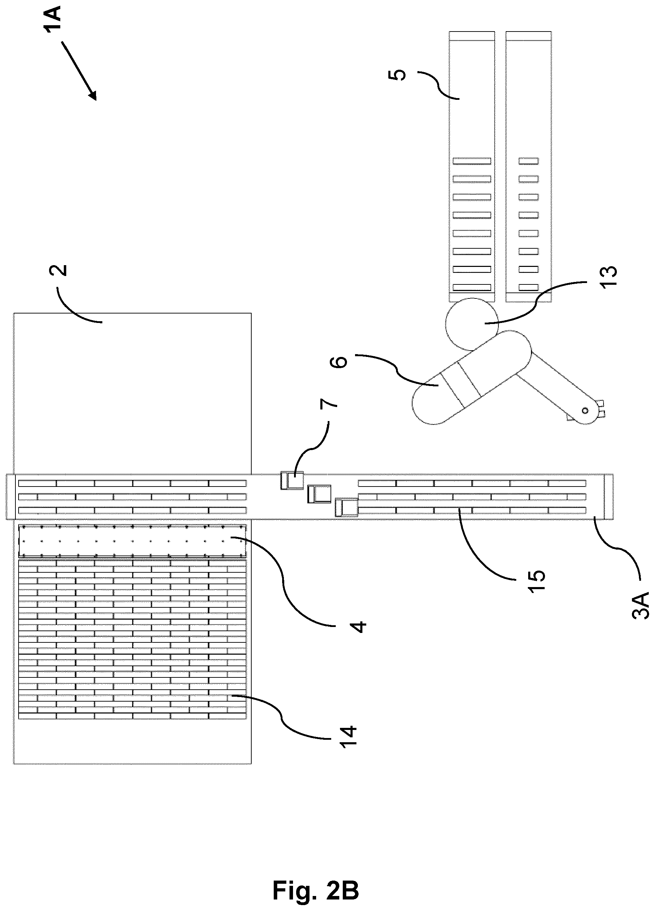

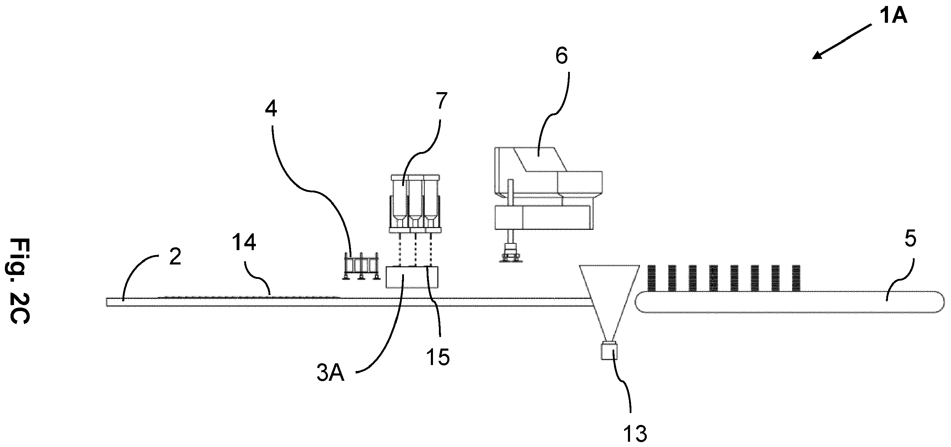

Die Figur 2B zeigt die zweite Vorrichtung 1A in Draufsicht. Die Figur 2C zeigt die zweite Vorrichtung 1A in Seitenansicht. Gleiche oder ähnliche Merkmale sind jeweils mit gleichen Bezugszeichen versehen.

Die Figur 3A zeigt eine dritte Vorrichtung 1B zur Herstellung von Solarmodulen 14 in 3-dimensionaler Ansicht. Die dritte Vorrichtung 1B ist ähnlich zu den in den Figuren 1A-1B und 2A-2C dargestellten ersten Vorrichtungen 1 und zweiten Vorrichtung 1A. Gleiche oder ähnliche Merkmale sind mit gleichen Bezugszeichen versehen.

Anstelle der Transporteinheit 2 der ersten Vorrichtung 1 umfasst die Vorrichtung 1B eine Transporteinheit 2A, die als Förderband ausgestaltet ist. Anstelle der in den Figuren 2A-2B gezeigten Transfereinheit 3A der zweiten Vorrichtung 1A umfasst die dritte Vorrichtung 1B eine Transfereinheit 3B, die als Förderband ausgestaltet ist. Das Förderband 3B ist senkrecht zu den Zeilen, die auf dem Förderband angeordnet sind bewegbar. Entsprechend sind die Transporteinheit 2A, die Transfereinheit 3B, die Handlingeinheit 6 und die Bereitstelleinheit 5 in einer Reihe senkrecht zu den Zeilen auf der Transporteinheit 2A und auf der Transfereinheit 3B angeordnet.

Ähnlich zu der in Figur 3A gezeigten Anordnung der dritten Vorrichtung 1B ist denkbar, dass die Transfereinheit 3 der in den Figuren 1A und 1B gezeigten ersten Vorrichtung 1 in Reihe mit der Transporteinheit 2, der Handlingeinheit 6 und der Bereitstelleinheit 5 angeordnet ist. In einer solchen Anordnung kann die Transfereinheit 3 ähnlich zu der Transfereinheit 3B senkrecht zu den auf der Transfereinheit 3 oder auf der Transporteinheit 2 angeordneten Zeilen bewegbar sein. Alternativ kann in einer solchen Anordnung die erste Position der Transfereinheit 3, in der die Transfereinheit 3 durch die Handlingeinheit 6 mit den Solarelementen 15 bestückt wird, mit der zweiten Position der Transfereinheit 3, in der die Solarelemente 15 durch die Aufnahmevorrichtung 4 von der Transfereinheit 3 aufgenommen und auf der Transporteinheit 2 abgelegt werden, übereinstimmen. Derart müsste die Transfereinheit nicht zwischen derer Be- und Entladung bewegt werden. Die in der Figur 3A gezeigte Anordnung hat dabei unter anderem den Vorteil, dass die Transfereinheit 3B gleichzeitig von der Aufnahmevorrichtung 4 entladen und von der Handlingeinheit 6 beladen werden kann.

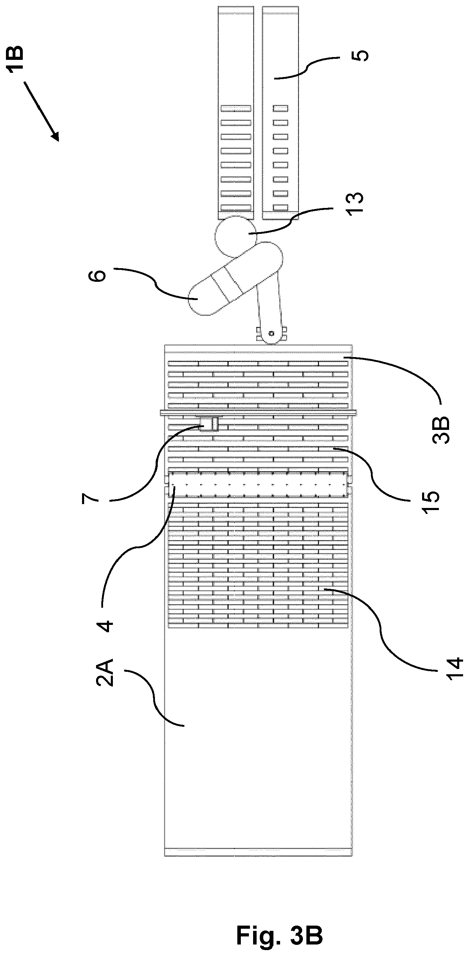

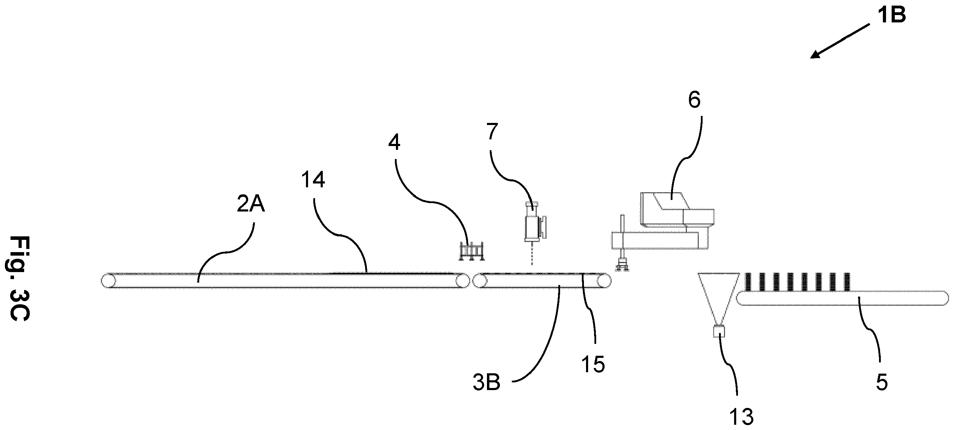

Die Figur 3B zeigt die dritte Vorrichtung 1B in Draufsicht. Die Figur 3C zeigt die dritte Vorrichtung 1B in Seitenansicht. Gleiche oder ähnliche Merkmale sind jeweils mit gleichen Bezugszeichen versehen.

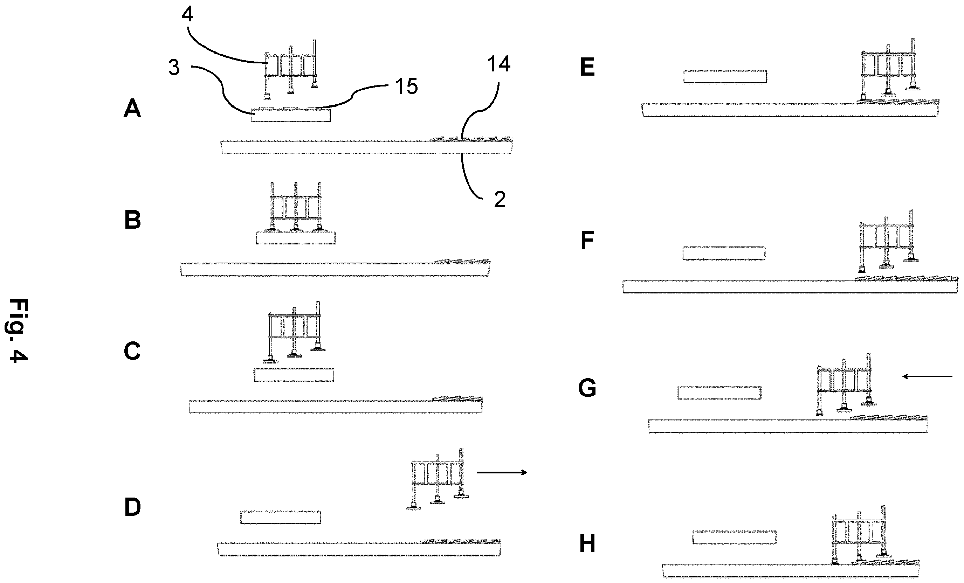

Figur 4A zeigt die Aufnahmevorrichtung 4, die über der Transfereinrichtung 3 angeordnet ist. Die Transfereinheit 3 ist wiederum über der Transporteinheit 2 angeordnet. Mit anderen Worten, die Transfereinheit 3 ist in der mit Bezug auf die Figur 1 beschriebenen zweiten Position der Transfereinheit 3 angeordnet. Alternativ kann die Transfereinheit 3 der ersten Vorrichtung 1 die Transfereinheit 3A der zweiten Vorrichtung 1A oder die Transfereinheit 3B der dritten Vorrichtung 1B sein. Die Transporteinheit 2 der ersten Vorrichtung 1 kann die Transporteinheit 2A der dritten Vorrichtung 1B sein.

Die Aufnahmevorrichtung 4 umfasst einen oder mehrere Sauger. Im gezeigten Beispiel umfasst die Aufnahmevorrichtung mehrere, in Reihen angeordnete Sauger, mit welchen die Zeilen durch die Aufnahmevorrichtung 4 aufgenommen werden können. Im gezeigten Beispiel sind die Sauger in drei Reihen angeordnet. Im gezeigten Beispiel erstrecken sich die jeweiligen Reihen der Sauger senkrecht zur Bildebene. Die Sauger sind dabei so angeordnet, dass ein erster Sauger oder mehrere in einer ersten Reihe angeordnete Sauger (in Figur 4 die linke Saugerreihe) nach einer vertikalen Bewegung der Aufnahmevorrichtung 4 hin zur Transfereinheit 3 eine Zeile bzw. ein oder mehrere Solarelemente 15 einer Zeile kontaktiert, während ein oder mehrere andere Sauger einer weiteren Reihe (in Figur 4 die Sauger der mittleren und rechten Saugerreihe) zu den Zeilen bzw. den Solarelementen 15 vertikal beabstandet sind.

Wird die vertikale Bewegung der Aufnahmevorrichtung 4 in Richtung der Transfereinheit 3 fortgeführt, so nähern sich die weiteren Sauger weiteren Zeilen bzw. weiteren Solarelementen 15 aus weiteren Zeilen. Bei dieser weiteren vertikalen Bewegung, also bei einer vertikalen Bewegung in Richtung der Transfereinheit 3 nachdem der erste Sauger oder die erste Saugerreihe bereits in Kontakt mit einer Solarzelle ist, wird dieser bzw. werden diese ersten Sauger vertikal verstellt, beispielsweise gegen eine Rückstellkraft. Die vertikale Verstellung der Sauger ermöglicht eine vertikale Bewegung der Aufnahmevorrichtung 4 nachdem die Sauger die Solarelemente 15 kontaktieren, ohne dabei die Solarelemente 15 zu zerstören oder zu beschädigen.

Durch die vertikale Verstellung können die Sauger relativ zu einander auf einer gleichen Höhe angeordnet sein. Durch die weitere vertikale Bewegung der Aufnahmevorrichtung 4 in Richtung der Transfereinheit 3 kontaktiert schließlich eine Anzahl zweiter Sauger, im gezeigten Beispiel die mittlere Reihe Sauger, und schließlich eine Anzahl dritter Sauger, im gezeigten Beispiel die rechte Reihe Sauger, wie in Figur 4B dargestellt, jeweils weitere Solarelemente 15.

Durch eine vertikale Bewegung der Aufnahmevorrichtung 4 weg von der Transfereinheit 3 werden die einzelnen kontaktierten Solarelemente 15 von der Transfereinheit 3 mittels der Aufnahmevorrichtung 4 aufgenommen. Ferner werden die die Sauger durch die Rückstellkraft in ihre ursprüngliche Position bewegt, sodass die Sauger auf unterschiedlichen Reihen unterschiedlich zu der Transfereinheit 3 und der Transporteinheit 2 beabstandet sind. Dies ist in Figur 4C dargestellt. Durch die unterschiedliche vertikale Anordnung der Sauger bzw. Saugerreihen, sind die aufgenommenen Solarelemente 15 bzw. Zeilen relativ zu der Transfereinheit 3 und der Transporteinheit 2 in unterschiedlichen Höhen vertikal beabstandet angeordnet.

Die Aufnahmevorrichtung 4 ist in eine Richtung senkrecht zu den Zeilen bzw. hin zum Solarmodul 14 translatorisch bewegbar, wie in Figur 4D dargestellt. Derart sind die Aufgenommenen Solarelemente 15 bzw. Zeilen durch unterschiedliche vertikale Anordnung der Sauger bzw. Saugerreihen relativ zu der Transporteinheit 2 in unterschiedlichen Höhen vertikal beabstandet angeordnet.

Die Aufnahmevorrichtung 4 kann Sauger, beispielsweise eine Reihe Sauger, umfassen, die nicht vertikal verstellbar sind. Beispielsweise kann die Saugerreihe, die den größten vertikalen Abstand zur Transfereinheit 3 bzw. zur Transporteinheit 2 aufweist, nicht vertikal verstellbar sein. Im gezeigten Beispiel ist dies die rechte Saugerreihe.

Wie in Figur 4E gezeigt, wird eine erste Zeile mit der Transporteinheit 2 bzw. mit einer bereits auf der Transporteinheit 2 angeordneten Zeile in Kontakt gebracht, während weitere Zeilen, im gezeigten Beispiel eine mittlere zweite und eine rechte dritte Zeile über der Transporteinheit 2 bzw. dem Solarmodul 14 vertikal beabstandet angeordnet sind. Mit anderen Worten: Die Zeilen werden zur Bestückung des Solarmoduls 14 miteinander jeweils nur soweit abgesenkt werden, dass nur die jeweils aktuell zu bestückende Zeile das Solarmodul 14 kontaktiert.

Durch eine Bewegung der Aufnahmevorrichtung 4 und/oder der Transporteinheit 2 senkrecht zu den Zeilen bzw. einer Längsachse der Zeilen können die weiteren, von der Aufnahmevorrichtung 4 aufgenommenen Zeilen auf der Transporteinheit 2 abgelegt werden, wie in den Figuren 4G und 4H dargestellt. Mit anderen Worten: Während des Bestückungsvorgangs des Solarmoduls 14 legt die zweite Zeile (im gezeigten Beispiel die Mittlere Zeile) eine unterschiedliche, nämlich eine längere, Wegstrecken zurück also die erste Zeile (im gezeigten Beispiel die linke Zeile).

So kann, wie in den Figuren 4E-4H dargestellt, eine zweite Zeile vertikal oberhalb einer geeigneten Ablageposition positioniert werden, um die Aufnahmevorrichtung 4 vertikal in Richtung der Transporteinheit 2 soweit zu bewegen, bis die von der Reihe zweiter Saugern aufgenommenen Solarelemente 15 die Transporteinheit 2 bzw. die zuvor abgelegte Zeile kontaktiert.

Bei diesem Vorgang wird die erste Reihe Sauger, wie in Figur 4H gezeigt, durch die Transporteinheit 2 kontaktiert. Die nach dem Kontakt der Transporteinheit 2 durch die erste Reihe Sauger weitergeführte vertikale Bewegung der Aufnahmevorrichtung 4 in Richtung der Transporteinheit 2 führt dabei zu einer vertikalen Verstellung der ersten Reihe Sauger.

Während des in den Figuren 4D-4H gezeigten Bestückungsvorgangs kann das Solarmodul 14 bzw. die Transporteinheit 2 beispielsweise ortsfest verbleiben oder sich kontinuierlich bewegen. Zwischen zwei Bestückungsvorgängen, also zwischen der Ablage der aufgenommenen drei Zeilen Solarelemente 15 und der Ablage weiterer drei aufgenommenen Solarelemente 15, kann sich das Solarmodul 14 bzw. die Transporteinheit 2 beispielsweise kontinuierlich und/oder getaktet bewegen, um weitere Fläche auf der Transporteinheit 2 zur Bestückung freizugeben.

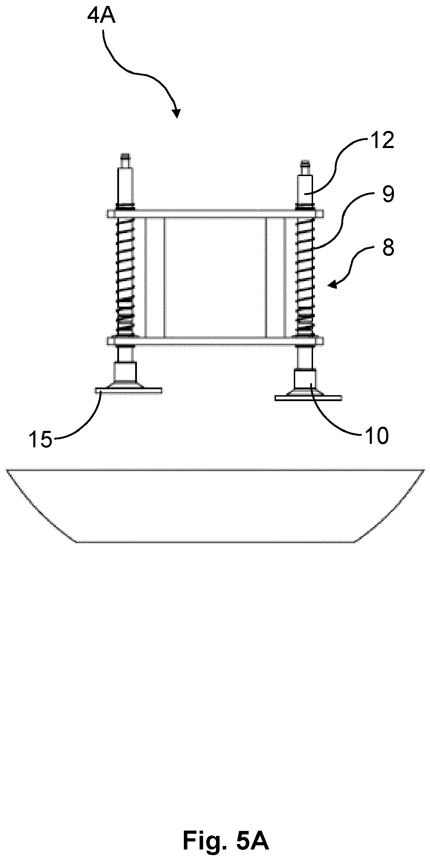

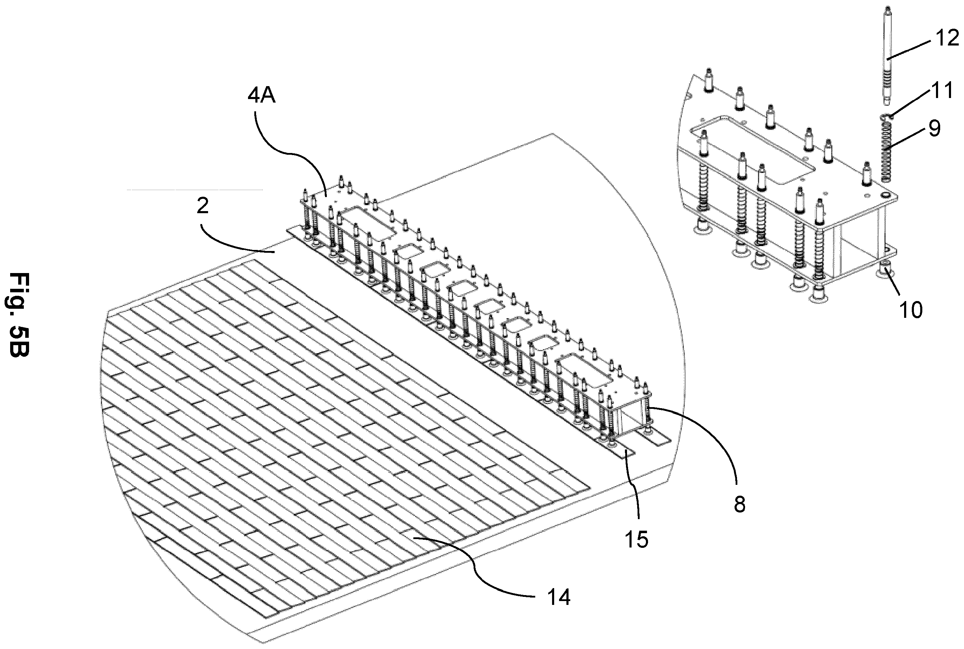

Die Figur 5A zeigt eine zweite Aufnahmevorrichtung 4A ähnlich der in den Figuren 1A-4H gezeigten ersten Aufnahmevorrichtung 4. Die zweite Aufnahmevorrichtung 4A umfasst eine Anzahl Sauger 8, die in zwei Reihen angeordnet sind, in Seitenansicht. Die Sauger 8 können den Saugern der ersten Aufnahmevorrichtung 4 entsprechen.

Die in der ersten Reihe angeordneten Sauger 8 sind relativ zu einer unter der Aufnahmevorrichtung 4A angeordneten Referenzebene, beispielsweise der Transfereinheit 3 oder der Transporteinheit 2, vertikal beabstandet in einem ersten Abstand angeordnet. Die in der zweiten Reihe angeordneten Sauger 8 sind relativ zu der Referenzebene vertikal beabstandet in einem zweiten Abstand angeordnet. Der zweite Abstand ist größer als der erste Abstand. Der erste und der zweite Abstand können durch die vertikale Bewegung der Aufnahmevorrichtung 4A relativ zu der Referenzebene verändert werden. Trifft dabei eine Sauger 8, der in der ersten Reihe angeordnet ist, auf die Referenzebene und wird die vertikale Bewegung der Aufnahmevorrichtung 4A in Richtung der Referenzebene fortgesetzt, so wird dieser Sauger 8 vertikal verstellt, insbesondere relativ zu der Aufnahmevorrichtung 4A bewegt. Im gezeigten Beispiel wird der Sauger 8 relativ zu der Aufnahmevorrichtung 4A in eine Richtung entgegen der Bewegungsrichtung der Aufnahmevorrichtung 4A, also weg von der Referenzebene, bewegt. Die vertikale Verstellung geschieht gegen eine Rückstellkraft, die im gezeigten Beispiel durch ein Federelement 9 bereitgestellt wird.

Die Sauger 8 umfassen jeweils einen Vakuumsauger 10, beispielsweise einen Saugkopf. Der Vakuumsauger 10 kann ein Solarelement 15 durch Erzeugung eines Unterdrucks auf der Oberfläche des Solarelements 15 aufnehmen und durch Wiederherstellung des Umgebungsdrucks oder durch Erzeugung eines Überdrucks ablegen. Der jeweilige Druckzustand kann beispielsweise durch eine an die Sauger 8 angeschlossene Pumpvorrichtung (nicht dargestellt) bereitgestellt werden.

Auf ähnliche Weise können die Solarelemente 15 auf der Transporteinheit 2 oder 2A sowie auf der Transfereinheit 3, 3A oder 3B durch Erzeugung eines Unterdrucks auf einer (beispielsweise der Aufnahmevorrichtung 4 und/oder der Handlingeinheit 6 abgewandten) Seite der Solarelemente 15 auf der jeweiligen Transport- oder Transfereinheit gehalten werden. Der Unterdruck kann beispielsweise über Öffnungen in der jeweiligen Transport- oder Transfereinheit, die mit der oder einer Pumpvorrichtung (nicht dargestellt) verbunden sind, bereitgestellt werden.

Die Figur 5A zeigt eine Aufnahmevorrichtung 4A in 3-dimensionaler Ansicht, die über der Transporteinheit 2 angeordnet ist. Gleiche oder ähnliche Merkmale sind mit gleichen oder ähnlichen Bezugszeichen versehen. Die Sauger 8 umfassen neben dem Federelement 9 im gezeigten Beispiel einen Sicherungsring 11 und einen Federstößel 12.

### Bezugszeichenliste

- 1: Erste Vorrichtung zur Herstellung von Solarmodulen
- 1A: Zweite Vorrichtung zur Herstellung von Solarmodulen
- 1B: Dritte Vorrichtung zur Herstellung von Solarmodulen
- 2: Transporteinheit der ersten und zweiten Vorrichtung
- 2A: Transporteinheit der dritten Vorrichtung
- 3: Transfereinheit der ersten Vorrichtung
- 3A: Transfereinheit der zweiten Vorrichtung
- 3B: Transfereinheit der dritten Vorrichtung
- 4: Erste Aufnahmevorrichtung
- 4B: Zweite Aufnahmevorrichtung
- 5: Bereitstelleinheit
- 6: Handlingeinheit
- 7: Dispenser
- 8: Sauger
- 9: Federelement
- 10: Vakuumsauger
- 11: Sicherungsring 11
- 12: Federstößel
- 13: Überwachungssystem

## Patentansprüche

1. Verfahren zum Herstellen von Solarmodulen (14), wobei Solarelemente (15) zu Zeilen zusammengesetzt werden, wobei jede Zeile wenigstens zwei Solarelemente (15) aufweist und wobei die Solarmodule (14) aus elektrisch miteinander verbundenen Zeilen aufgebaut werden, **dadurch gekennzeichnet, dass** zur Bestückung des Solarmoduls (14) wenigstens zwei Zeilen in einem Arbeitsgang aufgenommen und in unterschiedlichen Höhen über dem Solarmodul (14) bereitgehalten werden und dass die Zeilen zur Bestückung des Solarmoduls (14) miteinander jeweils nur soweit abgesenkt werden, dass nur die jeweils aktuell zu bestückende Zeile das Solarmodul (14) kontaktiert.

2. Verfahren nach Anspruch 1, **dadurch gekennzeichnet, dass** die verbleibenden Zeilen von dem Solarmodul (14) vertikal beabstandet bleiben.

3. Verfahren nach einem der vorangehenden Ansprüche, **dadurch gekennzeichnet, dass** die Zeilen mit vorzugsweise gegen eine Rückstellkraft vertikal verstellbaren Saugern (8) aufgenommen werden.

4. Verfahren zum Herstellen von Solarmodulen (14), insbesondere nach einem der vorangehenden Ansprüche, wobei Solarelemente (15) zu Zeilen zusammengesetzt werden, wobei jede Zeile wenigstens zwei Solarelemente (15) aufweist und wobei die Solarmodule (14) aus elektrisch miteinander verbundenen Zeilen aufgebaut werden, **dadurch gekennzeichnet, dass** zwei aufeinanderfolgende Zeilen während des Bestückungsvorgangs unterschiedliche Wegstrecken zurücklegen.

5. Verfahren nach einem der vorangehenden Ansprüche, **dadurch gekennzeichnet, dass** das Solarmodul (14) während des Bestückungsvorgangs mit den zwei aufeinanderfolgenden Zeilen ortsfest verbleibt.

6. Verfahren nach einem der vorangehenden Ansprüche, **dadurch gekennzeichnet, dass** das Solarmodul (14) zwischen zwei Bestückungsvorgängen getaktet bewegt wird.

7. Verfahren nach einem der vorangehenden Ansprüche, **dadurch gekennzeichnet, dass** das Solarmodul (14), insbesondere während des Bestückungsvorgangs kontinuierlich bewegt wird.

8. Verfahren nach einem der vorangehenden Ansprüche, **dadurch gekennzeichnet, dass** als Solarelemente (15) Streifen eines Wafers verwendet werden.

9. Vorrichtung zum Herstellen von Solarmodulen (14), wobei Solarelemente (15) zu Zeilen zusammengesetzt werden, wobei jede Zeile wenigstens zwei Solarelemente (15) aufweist und wobei die Solarmodule (14) aus elektrisch miteinander verbundenen Zeilen aufgebaut werden, **dadurch gekennzeichnet, dass** die Vorrichtung eine Aufnahmevorrichtung (4, 4A) umfasst, die dazu ausgelegt ist, zur Bestückung des Solarmoduls (14) wenigstens zwei Zeilen in einem Arbeitsgang aufzunehmen und in unterschiedlichen Höhen über dem Solarmodul (14) bereitzuhalten und die Zeilen zur Bestückung des Solarmoduls (14) miteinander jeweils nur soweit abzusenken, dass nur die jeweils aktuell zu bestückende Zeile das Solarmodul (14) kontaktiert.

10. Vorrichtung nach Anspruch 9, **dadurch gekennzeichnet, dass** die Aufnahmevorrichtung (4, 4A) dazu ausgelegt ist, die verbleibenden Zeilen von dem Solarmodul (14) vertikal beabstandet zu halten.

11. Vorrichtung nach einem der Ansprüche 9 oder 10, **dadurch gekennzeichnet, dass** die Aufnahmevorrichtung (4, 4A) vorzugsweise gegen eine Rückstellkraft vertikal verstellbaren Sauger (8) umfasst, die dazu ausgelegt sind, die Zeilen aufzunehmen, insbesondere die Zeilen in einem Arbeitsschritt aufzunehmen.

12. Vorrichtung, insbesondere nach einem der Ansprüche 9 bis 11, zum Herstellen von Solarmodulen (14), wobei Solarelemente (15) zu Zeilen zusammengesetzt werden, wobei jede Zeile wenigstens zwei Solarelemente (15) aufweist und wobei die Solarmodule (14) aus elektrisch miteinander verbundenen Zeilen aufgebaut werden, **dadurch gekennzeichnet, dass** die Vorrichtung eine Aufnahmevorrichtung (4, 4A) umfasst, die dazu ausgelegt ist, für mindestens zwei aufeinanderfolgende Zeilen während des Bestückungsvorgangs unterschiedliche Wegstrecken zurückzulegen.

13. Vorrichtung nach einem der Ansprüche 9 bis 12, **dadurch gekennzeichnet, dass** die Aufnahmevorrichtung (4, 4A) vorzugsweise während des Bestückungsvorgangs relativ zu dem Solarmodul (14) bewegbar ist, insbesondere in eine Richtung quer zu den Zeilen bewegbar ist.

14. Vorrichtung nach einem der Ansprüche 9 bis 13, wobei die Vorrichtung eine Transporteinheit (2, 2A) zur Aufnahme des Solarmoduls (14) umfasst, **dadurch gekennzeichnet, dass** die Vorrichtung dazu ausgelegt ist, die Transporteinheit (2, 2A) während des Bestückungsvorgangs mit den zwei aufeinanderfolgenden Zeilen ortsfest zu halten.

15. Vorrichtung nach einem der Ansprüche 9 bis 14, **dadurch gekennzeichnet, dass** die Vorrichtung dazu ausgelegt ist, die Transporteinheit (2, 2A) zwischen zwei Bestückungsvorgängen getaktet zu bewegen.

16. Vorrichtung nach einem der Ansprüche 9 bis 15, **dadurch gekennzeichnet, dass** die Vorrichtung dazu ausgelegt ist die Transporteinheit (2, 2A) insbesondere während des Bestückungsvorgangs kontinuierlich zu bewegen.
